# EUROPEAN PATENT APPLICATION

(11) **EP 3 674 905 A1**
(43) Date of publication of application: **01.07.2020**
(21) Application number: 18248231.5
(22) Date of filing: 28.12.2018
(51) Int. Cl.: G06F 13/40

(54) **PCI-E EXTENSION CABLE**

(71) Applicant: Dongguan Evn Electronics Co., Ltd., Sanzhong Village Qingxi Town, Dongguan City, Guangdong Province (CN)
(72) Inventor: OU, Li-Hui, Dongguan City (CN)
(74) Representative: 2K Patentanwälte Blasberg Kewitz & Reichel

(57) **Abstract**

A PCI-E extension cable (100) comprises a male connection end (11), a female connection end (12) and two transmission flexible boards (13, 14). The male connection end (11) comprises a first hard board (111), and a plurality of first conductive strips (112) disposed at intervals on the first hard board (111). The female connection end (12) comprises a second hard board (121), a plurality of second conductive strips (122) disposed at intervals on the second hard board (121), and a connector (123) connecting the plurality of second conductive strips (122). Each of the transmission flexible boards (13 or 14) is provided with a printed circuit (131 or 141) on at least one side thereof, each of the transmission flexible boards (13 or 14) is connected to the plurality of first conductive strips (112) and the plurality of second conductive strips (122) by the associated printed circuit (131 or 141), and at least one of the two transmission flexible boards (13 or 14) has a shielding layer (132 or 142) disposed on the side facing the other transmission flexible board (14 or 13) to form signal isolation.

## Description

### FIELD OF THE INVENTION

The present invention relates to a PCI-E extension cable, particularly to a PCI-E extension cable having flexible boards with printed circuits for replacing a conventional cable.

### BACKGROUND OF THE INVENTION

In order to meet the requirements of computer players to modify computers, many manufacturers have introduced PCI-E extension cords. However, the current commercially available PCI-E extension cords are generally implemented with a cable and two circuit boards, and the so-called cable is composed of a plurality of wires disposed side by side. When the two circuit boards are to be connected to the cable, the insulation layer at the two ends of the wires to which the cable belongs is manually stripped to obtain wire segments that can be soldered to the circuit boards, and then the cable and the circuit boards are soldered.

However, manual stripping can easily cause different stripping lengths or the wires are cut off accidentally, and the different stripping lengths will affect subsequent soldering. In addition, although the ends of the cable can be soldered after being stripped, there may be problems such as empty solder during soldering of the wires. The large numbers of pins of the PCI-E extension cord are disadvantage of troubleshooting, so that manufacturers can only try re-soldering to eliminate defects.

### SUMMARY OF THE INVENTION

A main object of the present invention is to solve the manufacturing problems derived from the implementation of the cable of prior art PCI-E extension cords.

To achieve the above object, the present invention provides a PCI-E extension cable comprising a male connection end, a female connection end and two transmission flexible boards. Wherein the male connection end comprises a first hard board, and a plurality of first conductive strips disposed at intervals and side by side on the first hard board, and the plurality of first conductive strips are respectively disposed on two surfaces of the first hard board. The female connection end comprises a second hard board, a plurality of second conductive strips disposed at intervals and side by side on the second hard board, as well as a connector connecting the plurality of second conductive strips, and the plurality of second conductive strips are respectively disposed on two surfaces of the second hard board. Each of the transmission flexible boards is provided with a printed circuit on at least one side thereof, and the associated printed circuit located on each of the transmission flexible boards is connected to the plurality of first conductive strips and the plurality of second conductive strips. The two transmission flexible boards are respectively connected to one lateral surface of the first hard board and the second hard board, and at least one of the two transmission flexible boards has a shielding layer disposed on the side facing the other transmission flexible board to form signal isolation.

In one embodiment, each of the printed circuits comprises a plurality of printed conductors spaced side by side and connected to one of the plurality of first conductive strips and one of the plurality of second conductive strips respectively, and the plurality of printed conductors have a same length.

In one embodiment, a spacing between any two of the adjacent printed conductors is constant.

In one embodiment, the two transmission flexible boards are bonded.

In one embodiment, the two transmission flexible boards do not have a bonding relationship.

In one embodiment, the two transmission flexible boards are formed by a flexible board being folded in half with a fold line.

In one embodiment, each of the transmission flexible boards has a cover film covering the printed circuit.

In one embodiment, the male connection end has two first extended cover films respectively disposed on one side of the first hard board and covering the plurality of first conductive strips, and the female connection end has two second extended cover films respectively disposed on one side of the second hard board and covering the plurality of second conductive strips, wherein one of the first extended cover films and one of the second extended cover films are integrally formed on the same side of the PCI-E extension cable.

In one embodiment, each of the plurality of first conductive strips is distinguished into a first bridging section connected to the printed circuit as well as a bare section extending integrally from the first bridging section, and each of the plurality of second conductive strips is distinguished into a second bridging section connected to the printed circuit as well as a soldering section extending integrally from the second bridging section and connected to the connector.

In an embodiment, the male connection end is distinguished into a first signal transmission area and a first power transmission area separated from the first signal transmission area, and the female connection end is distinguished into a second signal transmission area and a second power transmission area separated from the second signal transmission area. Each of the transmission flexible boards is distinguished into a signal transmission part connecting the first signal transmission area and the second signal transmission area, as well as a power transmission part connecting the first power transmission area and the second power transmission area. A spacing between the first signal transmission area and the first power transmission area is greater than a spacing between any two of the adjacent printed conductors.

According to the foregoing disclosure of the present invention, the present invention has the following features compared with the prior art: the present invention replaces the conventional cable with the two transmission flexible boards to eliminate the manual stripping procedure, and avoids poor soldering through the printed conductors of the transmission flexible boards. In addition, the structure of the present invention can specifically implement signal impedance control, which greatly reduces the influence of long distance transmission on the signal.

### BRIEF DESCRIPTION OF THE DRAWINGS

FIG. 1 is a first top structural view of an embodiment of the present invention;
FIG. 2 is a perspective structural view of an embodiment of the present invention;
FIG. 3 is a cross-sectional structural view of a male connection end of an embodiment of the present invention;
FIG. 4 is a cross-sectional structural view of a female connection end of an embodiment of the present invention;
FIG. 5 is a cross-sectional structural view of the male connection end of another embodiment of the present invention;
FIG. 6 is a second top structural view of an embodiment of the invention;
FIG. 7 is a schematic view showing a flexible board of the present invention bent to form two transmission flexible boards; and
FIG. 8 is a perspective structural view of the female connection end of another embodiment of the present invention.

### DETAILED DESCRIPTION OF THE PREFERRED EMBODIMENTS

The detailed description and technical contents of the present invention are described below with reference to the drawings.

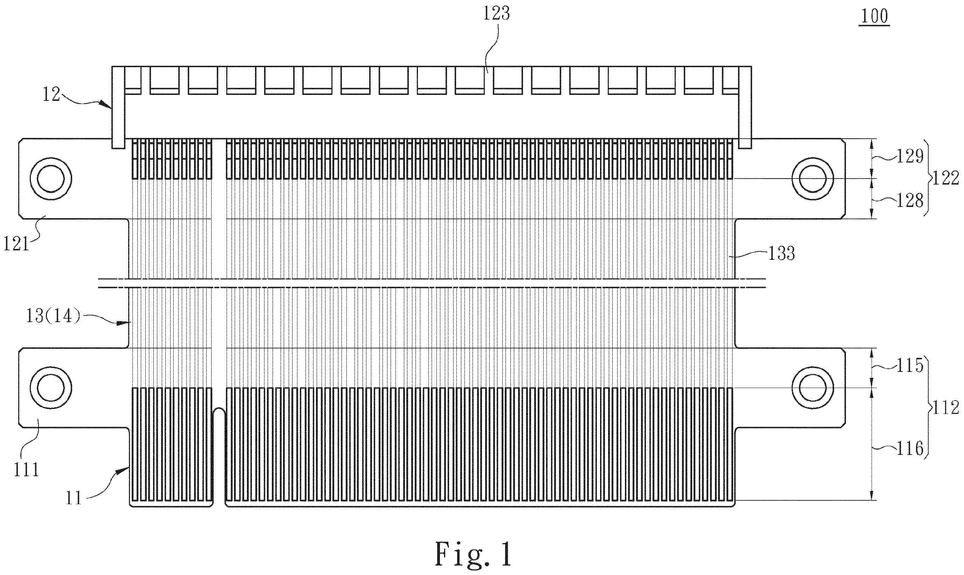

Referring to FIG. 1, FIG. 2, FIG. 3 and FIG. 4, the present invention provides a PCI-E extension cable 100. PCI-E is referred to Peripheral Component Interconnect Express and is a computer busbar specification. The PCI-E extension cable 100 can be used to connect a PCI-E interface card to a motherboard. The PCI-E extension cable 100 of the present invention comprises a male connection end 11, a female connection end 12 and two transmission flexible boards 13, 14. Wherein the male connection end 11 comprises a first hard board 111, and a plurality of first conductive strips 112 disposed at intervals and side by side on the first hard board 111. The first hard board 111 can be a FR-4 hard printed circuit board, and the plurality of first conductive strips 112 can be printed conductive parts on the FR-4 hard printed circuit board. Moreover, the plurality of first conductive strips 112 are respectively made of a metal material, and can be, for example, copper. The plurality of first conductive strips 112 are respectively disposed on two surfaces 113 and 114 of the first hard board 111. The plurality of first conductive strips 112 are all linear structures and their imaginary lines are not in contact. Further, each of the plurality of first conductive strips 112 can be distinguished into a first bridging section 115 and a bare section 116 extending integrally from the first bridging section 115, and the bare section 116 can be electrically connected to other devices.

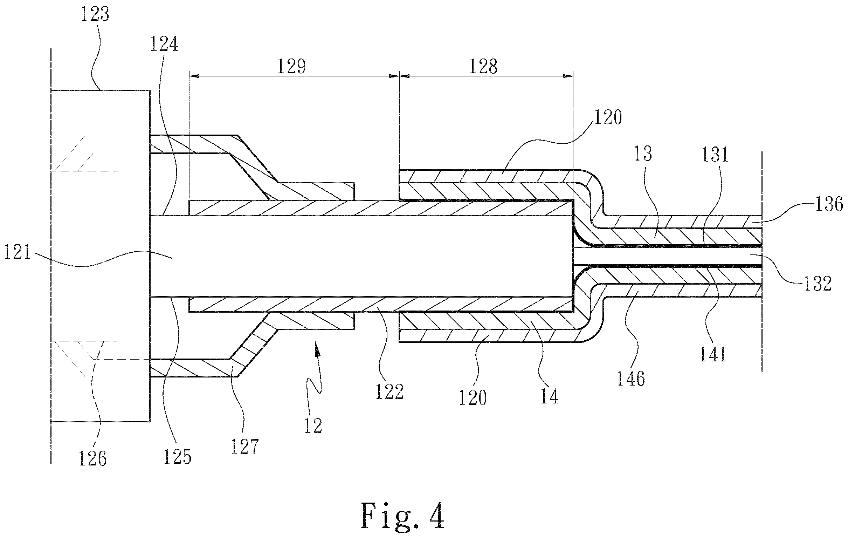

Please also referring to FIG. 4, the female connection end 12 comprises a second hard board 121, a plurality of second conductive strips 122 disposed at intervals and side by side on the second hard board 121, as well as a connector 123 connecting the plurality of second conductive strips 122. Wherein the second hard board 121 can also be a FR-4 hard printed circuit board, and the plurality of second conductive strips 122 are printed conductive parts on the FR-4 hard printed circuit board. Moreover, the plurality of second conductive strips 122 are respectively made of a metal material, and can be, for example, copper. The plurality of second conductive strips 122 are respectively disposed on two surfaces 124 and 125 of the second hard board 121, and the plurality of second conductive strips 122 are all linear structures and their imaginary lines are not in contact. Moreover, the connector 123 is implemented in a PCI-E specification. The connector 123 has a slot 126 and conductive terminals 127 respectively located at two sides of the slot 126. The conductive terminals 127 on each of the sides are respectively soldered to the plurality of second conductive strips 122 on one of the surfaces of the second hard board 121. Therefore, each of the plurality of second conductive strips 122 can be distinguished into a second bridging section 128 and a soldering section 129 extending integrally from the second bridging section 128.

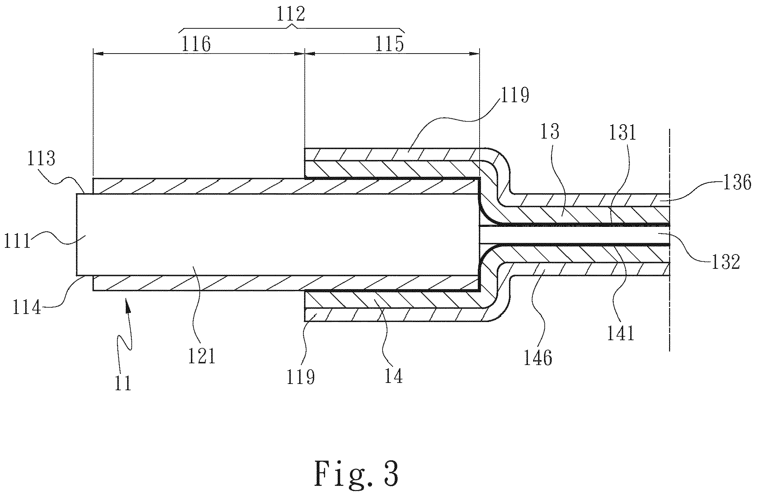

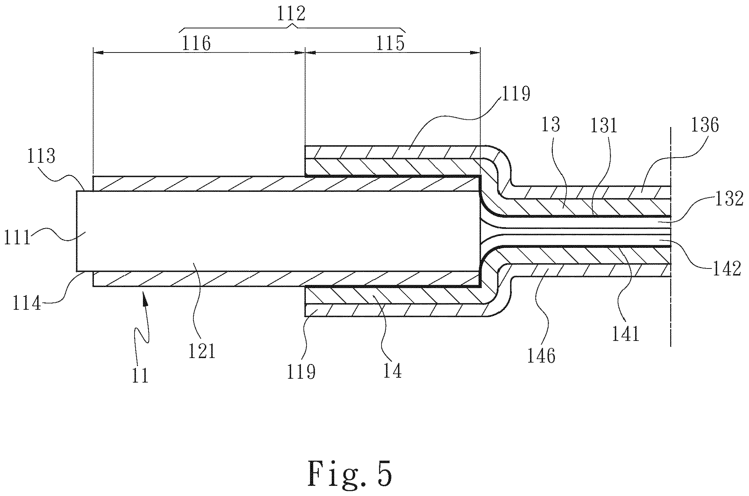

Referring to FIG. 3, FIG. 4 and FIG. 5, each of the transmission flexible boards 13 (14) of the present invention is provided with a printed circuit 131 (141) on at least one side, and each of the transmission flexible boards 13 (14) is provided with the printed circuit 131 (141) on both sides at most. The associated printed circuit 131 (141) located on each of the transmission flexible boards 13 (14) is connected to the plurality of first conductive strips 112 and the plurality of second conductive strips 122. Further, the printed circuits 131 (141) can be connected with the first bridging section 115 or the second bridging section 128 according to connection requirements. Each of the transmission flexible boards 13 (14) is not crimped during the process of connecting the first hard board 111 or the second hard board 121. Furthermore, the two transmission flexible boards 13 (14) are respectively connected to one side surface of the first hard board 111 and the second hard board 121. Further, at least one of the two transmission flexible boards 13 (14) has a shielding layer 132 (142) disposed on the side facing the other transmission flexible board 14 (13) to form signal isolation. Specifically, only one of the two transmission flexible boards 13 and 14 being provided with the shielding layer 132 (142) is also feasible, and the shielding layer 132 (142) is located between the transmission flexible boards 13, 14 to specifically generate shielding to avoid problems such as signal interference between the printed circuits 131, 141. In addition, the two transmission flexible boards 13, 14 can also be provided with the shielding layers 132, 142, and the shielding layers 132, 142 are also located between the two transmission flexible boards 13, 14 as shown in FIG. 5.

To continue from the above, for the purpose of more specifically implementing the signal impedance control, each of the printed circuits 131 (141) of the present invention comprises a plurality of printed conductors 133 (143) spaced side by side and connected to one of the plurality of first conductive strips 112 and one of the plurality of second conductive strips 122 respectively, and the plurality of printed conductors 133 (143) have a same length. Further, a spacing 152 between any two of the adjacent printed conductors 133 (143) is constant.

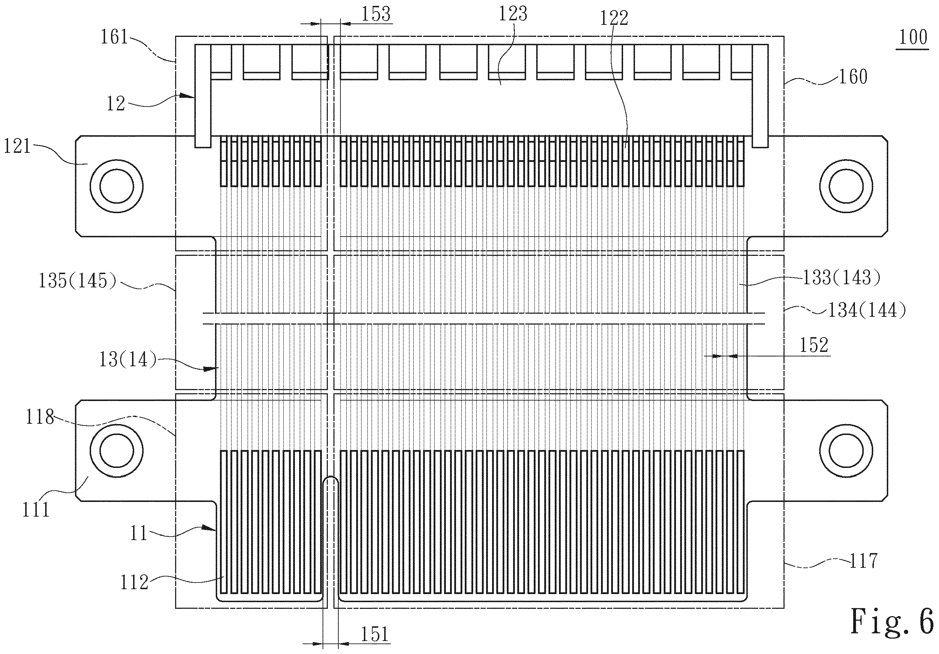

Referring to Fig. 6, the present invention distinguishes the functional areas of each of the components according to the PCI-E specification. The male connection end 11 is distinguished into a first signal transmission area 117 and a first power transmission area 118 separated from the first signal transmission area 117, and the female connection end 12 is distinguished into a second signal transmission area 160 and a second power transmission area 161 separated from the second signal transmission area 160. Each of the transmission flexible boards 13 (14) is distinguished into a signal transmission part 134 (144) connecting the first signal transmission area 117 and the second signal transmission area 160 respectively, as well as a power transmission part 135 (145) connecting the first power transmission area 118 and the second power transmission area 161 respectively. A spacing 151 between the first signal transmission area 117 and the first power transmission area 118 is greater than the spacing 152 between any two of the adjacent printed conductors 133 (143). In addition, the spacing 151 between the first signal transmission area 117 and the first power transmission area 118 is equal to a spacing 153 between the second signal transmission area 160 and the second power transmission area 161.

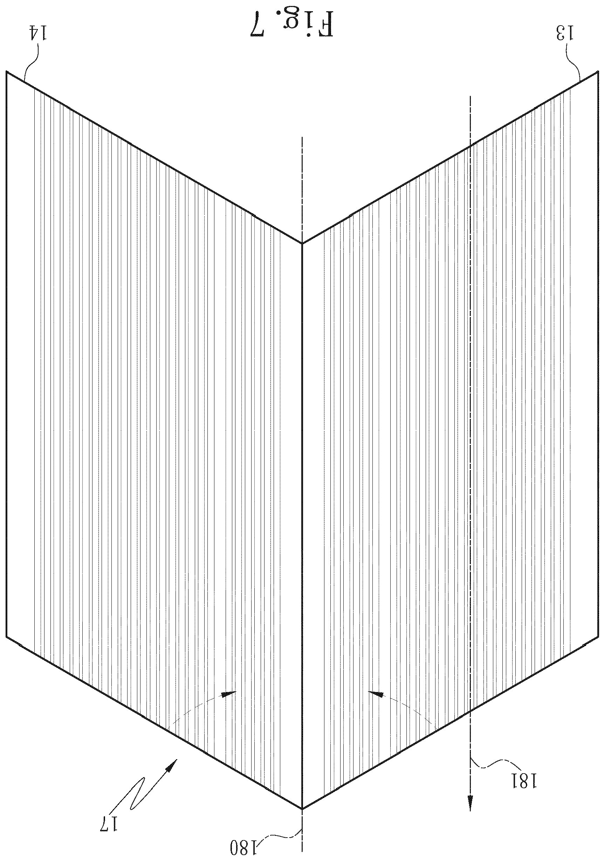

The two transmission flexible boards 13, 14 of the present invention are independent components, and the two can be bonded through a viscous material or the two do not have a bonding relationship, as shown in FIG. 5. In addition, please refer to FIG. 7, in an embodiment, the two transmission flexible boards 13 and 14 are formed by a flexible board 17 being folded in half with a fold line 180, and the fold line 180 is parallel to extension lines 181 of the two transmission flexible boards 13, 14.

Referring to FIG. 1, FIG. 2, FIG. 3 and FIG. 4 again, in one embodiment, each of the transmission flexible boards 13 (14) has a cover film 136 (146) covering the printed circuits 131, 141, respectively. In addition, the male connection end 11 has two first extended cover films 119 respectively disposed on one side of the first hard board 111 and covering the plurality of first conductive strips 112. The female connection end 12 has two second extended cover films 120 respectively disposed on one side of the second hard board 121 and covering the plurality of second conductive strips 122. The cover film 136 (146), one of the first extended cover films 119 and one of the second extended cover films 120 on the same side of the PCI-E extension cable 100 are integrally formed.

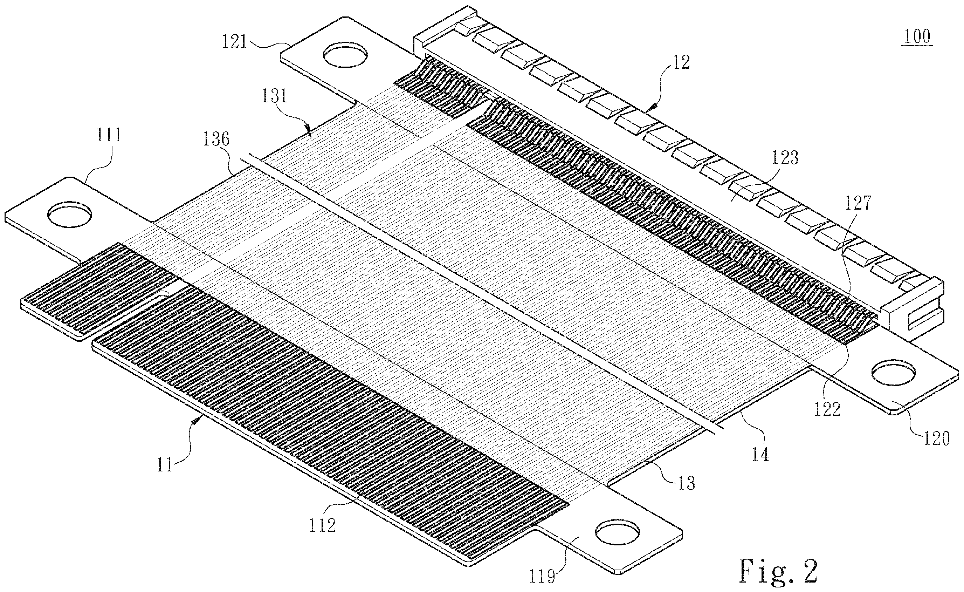

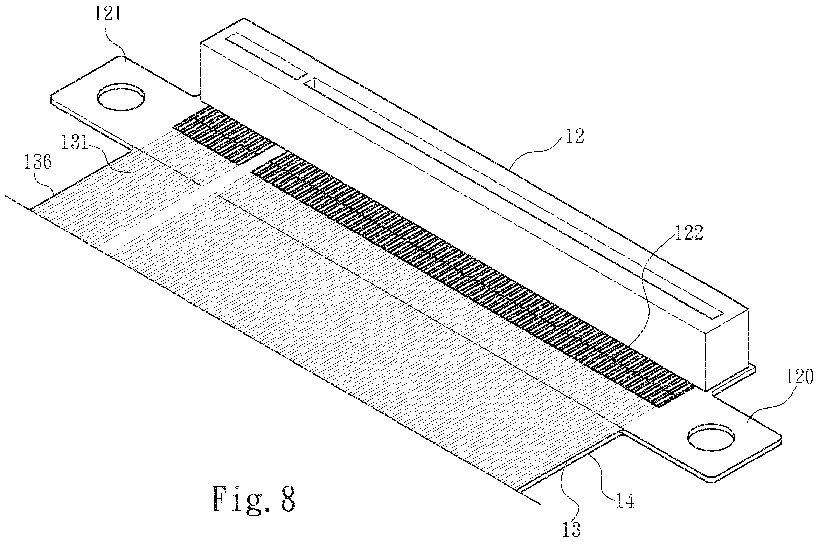

Furthermore, the manner in which the connector 123 of the present invention is disposed on the second hard board 121 can be adjusted according to implementation requirements. For example, the connector 123 can be implemented in the manner depicted in FIG. 2 or FIG. 8, but is not limited thereto.

## Claims

1. A PCI-E extension cable (100), comprising:
a male connection end (11), comprising a first hard board (111), as well as a plurality of first conductive strips (112) disposed at intervals and side by side on the first hard board (111), and the plurality of first conductive strips (112) being respectively disposed on both surfaces of the first hard board (111);
a female connection end (12), comprising a second hard board (121), a plurality of second conductive strips (122) disposed at intervals and side by side on the second hard board (121), as well as a connector (123) connecting the plurality of second conductive strips (122), and the plurality of second conductive strips (122) being respectively disposed on both surfaces of the second hard board (121); and
two transmission flexible boards (13, 14), each of the transmission flexible boards (13 or 14) being provided with a printed circuit (131 or 141) on at least one side thereof, each of the transmission flexible boards (13 or 14) being connected to the plurality of first conductive strips (112) and the plurality of second conductive strips (122) by the associated printed circuit (131 or 141), each of the transmission flexible boards (13 or 14) being connected only to one side surface of the first hard board (111) and the second hard board (121), and at least one of the two transmission flexible boards (13 or 14) having a shielding layer (132 or 142) disposed on the side facing the other transmission flexible board (14 or 13) to form signal isolation.

2. The PCI-E extension cable (100) as claimed in claim 1, wherein each of the printed circuits (131 or 141) comprises a plurality of printed conductors (133 or 143) spaced side by side and connected to one of the plurality of first conductive strips (112) and one of the plurality of second conductive strips (122) respectively, and the printed conductors (133 or 143) have a same length.

3. The PCI-E extension cable (100) as claimed in claim 2, wherein a spacing (152) between any two of the adjacent printed conductors (133 or 143) is constant.

4. The PCI-E extension cable (100) as claimed in claim 1, 2, or 3, wherein the two transmission flexible boards (13, 14) are bonded.

5. The PCI-E extension cable (100) as claimed in claim 1, 2, or 3, wherein the two transmission flexible boards (13, 14) do not have a bonding relationship.

6. The PCI-E extension cable (100) as claimed in claim 1, 2, or 3, wherein the two transmission flexible boards (13, 14) are formed by a flexible board (17) being folded in half with a fold line (180).

7. The PCI-E extension cable (100) as claimed in claim 1, 2, or 3, wherein each of the transmission flexible boards (13 or 14) comprises a cover film (136 or 146) covering the printed circuit (131 or 141) respectively.

8. The PCI-E extension cable (100) as claimed in claim 7, wherein the male connection end (11) comprises two first extended cover films (119) respectively disposed on one side of the first hard board (111) and covering the plurality of first conductive strips (112), and the female connection end (12) comprises two second extended cover films (120) respectively disposed on one side of the second hard board (121) and covering the plurality of second conductive strips (122), and the cover film (136 or 146), one of the first extended cover films (119) and one of the second extended cover films (120) on the same side of the PCI-E extension cable (100) are integrally formed.

9. The PCI-E extension cable (100) as claimed in claim 1, 2 or 3, wherein each of the plurality of first conductive strips (112) is distinguished into a first bridging section (115) connected to the printed circuit (131 or 141) and a bare section (116) extending integrally from the first bridging section (115), and each of the plurality of second conductive strips (122) is distinguished into a second bridging section (128) connected to the printed circuit (131 or 141) and a soldering section (129) extending integrally from the second bridging section (128) and connected to the connector (123).

10. The PCI-E extension cable (100) as claimed in claim 2 or 3, wherein the male connection end (11) is distinguished into a first signal transmission area (117) and a first power transmission area (118) separated from the first signal transmission area (117), the female connection end (12) is distinguished into a second signal transmission area (160) and a second power transmission area (161) separated from the second signal transmission area (160), each of the transmission flexible boards (13 or 14) is distinguished into a signal transmission part (134 or 144) connecting the first signal transmission area (117) and the second signal transmission area (160) respectively, as well as a power transmission part (135 or 145) connecting the first power transmission area (118) and the second power transmission area (161) respectively, and a spacing (151) between the first signal transmission area (117) and the first power transmission area (118) is greater than the spacing (152) between any two of the adjacent printed conductors (133 or 143).
